Europäisches Patentamt

European Patent Office

Office européen des brevets

(19)

(11) Veröffentlichungsnummer: **0 302 165 B1**

(12) **EUROPÄISCHE PATENTSCHRIFT**

(45) Veröffentlichungstag der Patentschrift: **23.10.91**

(51) Int. Cl.⁵: **H01L 21/56**, H01L 23/29, H01L 23/31

(21) Anmeldenummer: **88103232.0**

(22) Anmeldetag: **03.03.88**

(54) **Verfahren zum Einkapseln von mikroelektronischen Halbleiter- und Schichtschaltungen.**

(30) Priorität: **30.07.87 DE 3725269**

(43) Veröffentlichungstag der Anmeldung:
**08.02.89 Patentblatt 89/06**

(45) Bekanntmachung des Hinweises auf die
Patenterteilung:
**23.10.91 Patentblatt 91/43**

(84) Benannte Vertragsstaaten:
**DE FR GB IT**

(56) Entgegenhaltungen:
**EP-A- 0 122 687**
**DE-A- 3 442 131**

(73) Patentinhaber: **Messerschmitt-Bölkow-Blohm**
**Gesellschaft mit beschränkter Haftung**
**Robert-Koch-Strasse**
**W-8012 Ottobrunn(DE)**

(72) Erfinder: **Möller, Werner, Dr.**
**Ravensburger Strasse 77**
**W-7900 Ulm(DE)**
Erfinder: **Ulmann, Andreas**
**Grimmstrasse 1**
**W-7318 Lenningen(DE)**

## Beschreibung

Die Erfindung bezieht sich auf ein Verfahren zum Einkapseln von mikroelektronischen Hybrid-Halbleiterschaltungen oder von mikroelektronischen Halbleiterbauelementen, z.B. Tape Automated Bondings, gemäß dem Gattungsbegriff des Anspruchs 1

Ein solches Verfahren ist durch die DE-OS 34 42 131 der Anmelderin bekannt geworden. Hierbei handelt es sich um ein Verfahren zur Metallfolienverkapselung mit einer Kunststoffabdeckung als mechanischen Schutz für mikroelektronische Schaltungen, insbesondere für "Chip and Wire-Technik". Dieses Verfahren eignet sich für Zuverlässigkeitselektronik, da bei seiner Entwicklung schon auf höchste Zuverlässigkeit der Verkapselung bzw. auf einen hermetisch dichten Verschluß der Schaltungen geachtet worden ist. Nun hat es sich aber gezeigt, daß bei langzeitig und unter extremen Bedingungen beanspruchten Verkapselungen ein Eindiffundieren von Feuchte und korrosiven Gasen bis zu den Kontaktstellen nicht völlig ausgeschlossen werden kann, da bei einer Verklebung der gasdichten und rißfesten Metallfolie ein Fügespalt zwischen Folie und Substrat bleibt.

Der vorliegenden Erfindung liegt die Aufgabe zugrunde, die vorgenannten Nachteile zu beseitigen und ein Verfahren zur hermetischen Verlötung der Folie mit der Keramik aufzuzeigen, mit dem ein Eindiffundieren von Feuchte und korrosiven Gasen ausgeschlossen wird.

Diese Aufgabe wird durch die im Anspruch 1 aufgezeigten Maßnahmen gelöst. Im Nebenanspruch ist eine weitere Variante für einen Spezialfall aufgezeigt und in den Unteransprüchen sind Verfahrensmöglichkeiten und Einzelverfahrensmaßnahmen angegeben. In der nachfolgenden Beschreibung wird ein Ausführungsbeispiel und ein Spezialfall erläutert. Die Figuren der Zeichnung dienen der weiteren Erläuterung der Erfindung. Es zeigen:

Fig. 1     den Aufbau einer nach dem Stand der Technik eingekapselten mikroelektronischen Halbleiter- und Schichtschaltung,

Fig. 1a     den Aufbau einer nach dem neuen Verfahren eingekapselten mikroelektronischen Halbleiter- und Schichtschaltung.

Fig. 2a     das 1. Formwerkzeug mit dem eine ausgestanzte, einseitig mit Polyester kaschierte Chromnickelstahlfolie oder eine Kupferfolie kalt verformt wird,

Fig. 2b     das zweite Formwerkzeug mit dem die ausgestanzte Folie umgebördelt wird,

Fig. 2c     das dritte Formwerkzeug mit einem Preßdruckstempel, mit dem unter ca. 1 bis 5 bar und 10 KA eine Widerstandsverschweißung der umgebördelten Folie durchgeführt wird und anschließend das Ganze mit einem gefüllten Epoxidharz übergossen, gehärtet bzw. verfestigt wird.

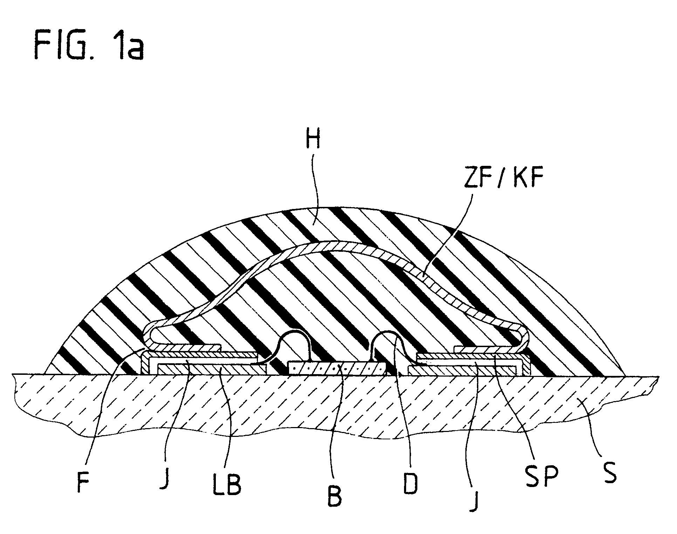

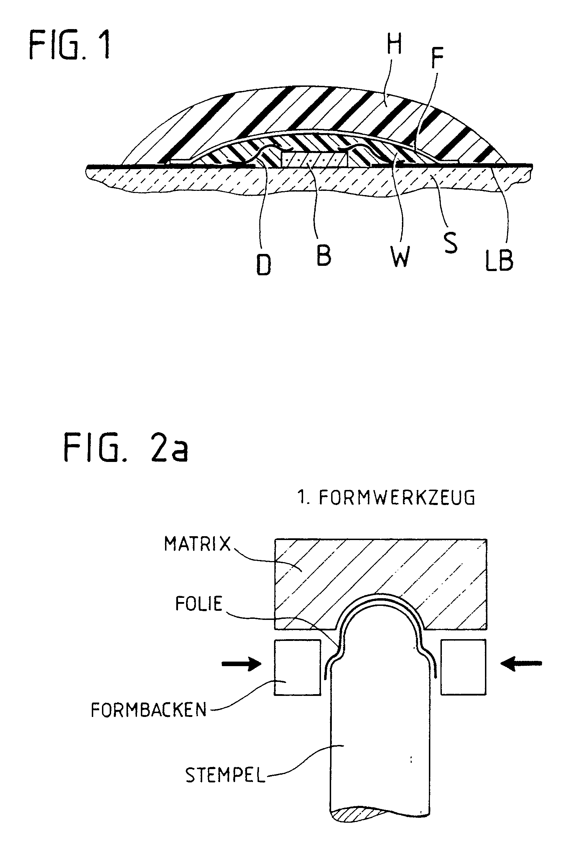

Das nachfolgend beschriebene Verfahren baut auf dem Verfahren auf, nach dem die in Fig. 1 dargestellte eingekapselte Schaltung hergestellt worden ist. Auf einem Substrat S befindet sich der durch die Bonddrähte D elektrisch mit den Leiterbahnen LB' verbundene elektronische Baustein B. Über diese Anordnung wird eine heißsiegelfähige Schicht W aufgebracht und mit einer Metall-Verbundfolie F bedeckt und mittels eines erhitzten Hohlstempels auf die weiche Schicht aufgepreßt. Nach Verfestigung und Abkühlung wird das Ganze mit einem Epoxidharz H vergossen.

Bei dem neuen Verfahren zur hermetischen Verlötung der Folie ZF mit der Keramik wird die mikroelektronische Schichtschaltung B an den zu verkapselnden Stellen mit einem Isolierkranz I - z.B. Chip-Stellen - bedruckt und so die Leiterbahnen LB isoliert. Anschließend folgt eine Silber-Palladium-Beschichtung oder, wenn die Leiterbahnen LB aus Kupfer sind, eine Kupferpastenbeschichtung in ca. 50 bis 150 $\mu$m Dicke. Die Bindemittel-Ausheizung sowie der Keramik-Einbrand erfolgt wie üblich bei 850° bzw. 930°C, bei Kupferpasten unter leicht reduktiver Schutzgas- bzw. Formiergas-Atmosphäre. Eine mit Polyäthylen in 5 - 25 $\mu$m Dicke kaschierte oder mit Hartwachs lackierte Zinnfolie ZF, die eine Dicke von 25 - 100 $\mu$m, vorzugsweise jedoch 50 $\mu$m aufweist, wird der vorgesehenen Verkapselung angemessen ausgestanzt, verformt, mit einem Saugheber über die gebondete IC- oder Hybridschaltung B gestülpt und mit einem induktiv beheizten Hülsenstempel HS auf die Silber-Palladium- bzw. Kupferschicht SP unter einem Druck von 1 - 5 bar und bei einer Temperatur von rund 250°C aufgelötet. Je nach Druck kann hier eine Toleranz von ± 30°C gegeben sein.

Das Polyäthylen bzw. Hartwachs schmilzt an der Lötfuge F, isoliert aber andererseits gegenüber dem Bonddraht D bzw. der Schaltung B. Eine Oberflächenoxydation der Kupferfolie KF erleichtert eine Umsetzung und damit die Bindung bzw. Haftung zur Keramik.

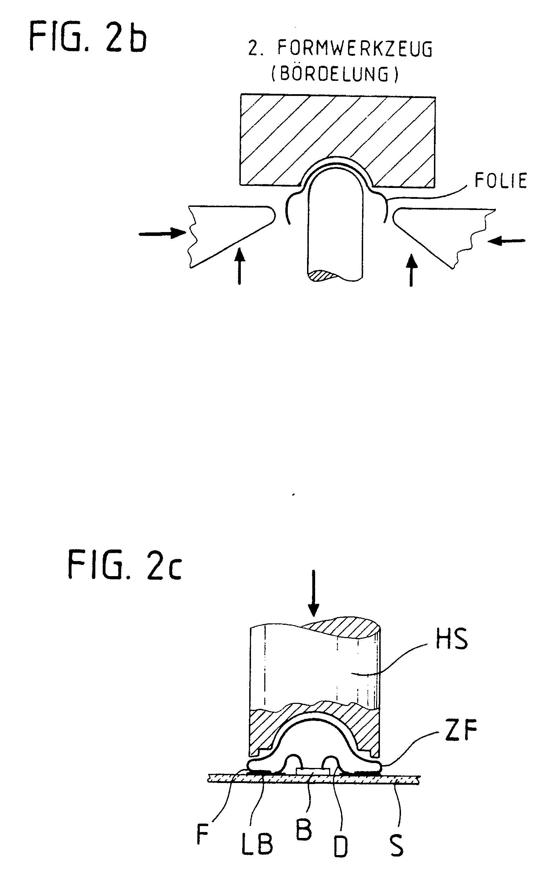

Als Folie ZF/KF kann auch eine einseitig mit Polyester (PETP) kaschierte Chromnickelstahlfolie ausgestanzt, kalt verformt und umbördelt werden. In den Fig 2a und 2b ist skizziert, wie mit einem 1. Formwerkzeug die Folie mit Hilfe von Matrix, Formbacken und Formstempel ihre entsprechende Form erhält und in Figur 2b ist skizziert, wie mit einem 2. Formwerkzeug die Umbördelung des vorgeformten Folienstückes durchgeführt wird. Anschließend an diese Verformungen wird mit einem Preßdruckstempel unter ca. 1 - 5 bar und 10 KA eine Widerstandsverschweißung durchgeführt - wie in Fig. 2c skizziert - und mit einem gefüllten Epoxidharz H übergossen, gehärtet bzw. verfestigt. Die Schaltung B wird mit einem Silkontropfen überzogen bzw. isoliert, anschließend mit der Metallfolienkappe ZF/ZK überdeckt und unter leichtem Andruck mit einem YAG-Nd-Laser angeschweißt.

Mikroelektronische Schaltungen, vor allem IC's, die kurzfristig 400°C ertragen können, werden an den vorgesehenen Lötstellen - wie ·bereits beschrieben - mit einem Dielektrikumsdruck isoliert und eingebrannt. Nach dem Chip- und Drahtbonden wird ein Silberglaslot mit einem Silbergehalt von rund 70% Silber auf die Lötstellen gestempelt, bei 300°C etwa 15 Minuten lang ausgeheizt und anschließend mit der Metallfolienkappe bei 380°C in 30 Minuten unter leichtem Andruck z.B. in einer Kohleform aufgelötet. Statt der Silberglaslotpaste können auch niedrigschmelzende Glas-Metallpasten, Cu-Dickschichtpaste oder Ag/Pd-Pasten verwendet werden. Zur Isolation der Bonddrähte und der Schaltung werden sogenannte Conformal-Coatings aus hitzebeständigem, nicht gasenden, hochreinen Silikonharz vorgeschlagen. Die 5 bis 100 μm starke Metallfolie aus Cu, Sn, Al etc. kann ein- oder zweiseitig mit einer Kunststoff-Folie (PE oder PETP), mit Hartwachs, PI u.ä. isoliert werden. Diese Isolierschicht wird vorzugsweise eine Dicke zwischen 3 und 50 μm aufweisen. Die Verlötung kann durch Laserlöten mittels eines YAG-Nd-Lasers geringer Leistung und bei schwacher Fokussierung erfolgen. Es ist aber auch eine Widerstandslötung möglich, vorzugsweise ein Kontakt- oder Induktionslöten mit heizbarem Stempel entsprechender Form, besonders von verkupferter Keramik mit Sn-Folie oder Cu- bzw. Al-Folie, die mit Silber-Palladium-Schichten versehen sind.

Dadurch ist ein Verfahren geschaffen, das neben den bereits erwähnten Vorteilen und Vorzügen auch eine rationelle Verkapselung gegenüber verschweißten Gehäusen aufweist.

**Patentansprüche**

1. Verfahren zum Einkapseln von mikroelektronischen "Chip and Wire" Hybrid-Halbleiterschaltungen oder von mikroelektronischen Halbleiterbauelementen, z.B. TABs (Tape Automated Bonding), wobei die auf einem Substrat (S) aufgebrachten Bauelemente (B) mit einer Kunststoffschicht (W)übergrossen, mit einer Kunststoff-Metall-Verbundfolie (ZF) abgedeckt und schließlich mit Kunstharz (H) verkapselt werden, **dadurch gekennzeichnet,** daß die mikroelektronische Schichtschaltung an den zu verkapselnden, für die Bauelemente (B) vorgesehenen Stellen auf der Leiterbahn (LB) aus Keramik mit einem Isolierkranz (J) bedruckt wird, anschließend eine Silber-Palladium- (SP) oder - bei KupferLeiterbahnen - eine Kupferpasten-Beschichtung in ca. 50 bis 150mm Dikke aufgebracht wird, dann eine mit Polyäthylen kaschierte oder mit Hartwachs lackierte Zinnfolie (ZF), die der Verkapselung entsprechend ausgestanzt und verformt wird, mit einem Saugheber über das gebondete Bauelement (B) gestülpt und mit einem induktiv beheizten Hülsenstempel (HS) auf die Silber-Palladium bzw. Kupferschicht (SP) unter einem Druck von 1 bis 5 bar bei 250°C aufgelötet wird.

2. Verfahren nach Anspruch 1, **dadurch gekennzeichnet,** daß die Bindemittel-Ausheizung sowie der Keramik-Einbrand in üblicher Weise bei 850° bzw. 930°C erfolgt, bei Kupferpasten unter leicht reduktiver Schutzgas- bzw. Formiergas-Atmosphäre.

3. Verfahren nach Anspruch 1, **dadurch gekennzeichnet,** daß die Polyäthylen-Kaschierschicht der Zinnfolie (ZF) eine Dicke von 5 bis 25 mm aufweist und die Zinnfolie (ZF) im Dickenbereich von 25 bis 100 mm, vorzugsweise aber bei 50 mm liegt.

4. Verfahren nach Anspruch 1, **dadurch gekennzeichnet,** daß eine einseitig mit Polyester (PETP) kaschierte Chromnickelstahl- oder Kupfer- folie ausgestanzt, kalt verformt und umbördelt wird und mittels eines Preßdruckstempels unter ca. 1 bis 5 bar und 10 KA eine Widerstandsschweißung durchgeführt und mit einem gefüllten Epoxidharz übergossen, gehärtet bzw. verfestigt wird.

5. Verfahren nach Anspruch 1, **dadurch gekennzeichnet,** daß die Schaltung mit einem Silikontropfen überzogen und dadurch isoliert wird und anschließend mit einer Metallfolienkappe (ZF, KF) überdeckt und unter leichtem Andruck mit einem YAG-Nd-Laser angeschweißt wird.

6. Verfahren nach Anspruch 1, **dadurch gekennzeichnet,** daß mikroelektronische Schaltungen, die kurzfristig Temperaturen von 400°C vertragen, an den vorgesehenen Lötstellen mit einem Dielektrikumsdruck isoliert und eingebrannt werden und nach dem Bauelemente- und Drahtbon-den ein Silberglaslot mit einem ca. 70%igen Silbergehalt auf die Lötstellen gestempelt, bei 300°C etwa 15 Minuten ausgeheizt und anschließend eine Metall-Folienkappe bei 380°C in 30 Minuten unter leichtem Andruck - beispielsweise in einer Kohleform - aufgelötet wird.

7. Verfahren nach einem oder mehreren der Ansprüche 1 bis 6, **dadurch gekennzeichnet,** daß die Verlötung der Metallfolie (ZF) mit einem YAG-Nd-Laser geringer Leistung und bei schwacher Fokussierung durchgeführt wird.

8. Verfahren nach einem oder mehreren der Ansprüche 1 bis 7, **dadurch gekennzeichnet,** daß als Lötverfahren das an sich bekannte Widerstandslöten, vorzugsweise aber das Induktionslöten eingesetzt wird, wobei letzteres mit einem heizbaren Stempel entsprechender Form, vorzugsweise von verkupferter Keramik mit Sn-Folie oder Cu- oder Al-Folie mit Silber oder Palladiumschichten durchgeführt wird.

## Claims

1. Process of encapsulating micro-electronic "chip and wire" hybrid semi-conductor circuits or micro-electronic semi-conductor components, for example TABs (Tape Automated Bonding), wherein components (B) applied to a substrate (S) are overlaid by a synthetic-material layer (W), covered with a synthetic-material metal bonding foil (ZF) and finally encapsulated in synthetic resin (H), characterised in that insulating rings (J), provided for the components (B) and located on the ceramic conducting path (LB), are printed onto the micro-electronic layer circuit at positions to be encapsulated, subsequently a silver-palladium (SP) coating, or in the case of copper conductor paths a copper-paste coating, of from 50 to 150mm thickness is applied, and then a polyethylene laminated or hard-wax lacquered tin foil (ZF), which is punched out and deformed to correspond with the encapsulation, is inverted over the bonded component (B) by means of a syphon and soldered, by means of an inductively heated sleeve punch (HS), onto the silver-palladium or copper layer (SP) at a pressure of between 1 to 5 bar at 250° C.

2. Process according to Claim 1, characterised in that the heating of the bonding medium and the ceramic stoving is carried out in conventional manner, between 850° and 930° C, for copper pastes under a slightly reductive atmosphere of protective gas or molding gas.

3. Process according to Claim 1, characterised in that the polyethylene laminate layer of the tin foil (ZF) has a thickness of 5 to 25mm, and the tin foil (ZF) has a thickness in the region of 25 to 100mm, preferably around 50mm.

4. Process according to claim 1, characterised in that a chromium-nickel-steel or copper foil, which is single-sidedly laminated with polyester (PETP), is punched out, cold deformed and crimped, and subsequently resistance welding is carried out by means of a pressure punch at from 1 to 5 bar and 10 KA and a filled epoxy resin is poured over it and hardened or solidified.

5. Process according to Claim 1, characterised in that the circuit is coated with a silicon drop and thus insulated, and subsequently covered with a metal-foil cap (ZF, KF) and welded on under slight pressure by means of a YAG-Nd laser.

6. Process according to Claim 1, characterised in that micro-electronic circuits for short-term exposure to temperatures of 400° C are insulated and welded at the soldering locations provided, by means of dielectric pressure, and after bonding of the components and the wires, a silver-glass solder having a silver content of about 70% is stamped onto the soldering locations and heated at 300° C for approximately 15 minutes, and then a metal-foil cap is soldered on at 380° C, within 30 minutes, under a slight pressure - for example in a carbon form.

7. Process according to one or more of Claims 1 to 6, characterised in that soldering of the metal foil (ZF) is carried out by means of a YAG-Nd laser of low output and with weak focussing.

8. Process according to one or more of claims 1 to 7, characterised in that the soldering method to be used is the generally known resistance soldering, preferably induction soldering, in which respect the latter is carried out by means of a heated punch of corresponding shape, preferably of copper plated ceramic with Sn foil or Cu or Al foil with silver or palladium layers.

## Revendications

1. Procédé d'enrobage de circuits à semi-conducteurs hybrides à "puce et fils" de micro-électronique ou d'éléments à semi-conducteurs de micro-électronique, par exemple de TAB (transfert automatique sur bande), dans lequel on applique une couche de matière plastique (W) sur les éléments (B) placés sur un substrat (S), on les recouvre d'un film composite métal-matière plastique (ZF) et on les enrobe enfin de résine synthétique (H), **caractérisé** en ce qu'on réalise par impression une couronne isolante (J) sur la piste conductive (LB) de céramique aux endroits prévus pour les éléments (B) à enrober du circuit à couches de micro-électronique, on applique ensuite un revêtement argent-palladium (SP) ou - dans le cas de pistes conductives en cuivre - de pâte de cuivre en épaisseur d'environ 50 à 150 μm, on place au moyen d'un dispositif de manipulation à aspiration une feuille d'étain (ZF) contre-collée de polyéthylène ou revêtue de cire solide, découpée et formée en fonction de l'enrobage à réaliser, sur l'élément (B) assemblé et on la soude à l'aide d'un poinçon creux (HS) chauffé par induction sur la couche argent-palladium ou la couche de cuivre (SP) sous une pression de 1 à 5 bars, à 250° C.

2. Procédé selon la revendication 1, **caractérisé** en ce que le chauffage du produit de liaison ainsi que la cuisson de la céramique sont réalisés de manière connue à 850° ou 930° C, dans le cas de pâtes de cuivre sous atmosphère contrôlée légèrement réductrice ou sous atmosphère de forming gaz.

3. Procédé selon la revendication 1, **caractérisé** en ce que la couche contre-collée de polyéthylène de la feuille d'étain (ZF) a une épaisseur comprise entre 5 et 25 μm et l'épaisseur de la couche d'étain (ZF) se situe dans la plage de 25 à 100 μm, et est de préférence égale à 50 μm.

4. Procédé selon la revendication 1, **caractérisé** en ce qu'on découpe par poinçonnage une feuille d'acier au chrome-nickel ou de cuivre contre-collée sur une face de polyester (PETP), on la forme à froid et on la borde, puis on la soude par résistance à l'aide d'un poinçon à pression sous une pression d'environ 1 à 5 bars et 10 KA, on la recouvre de résine époxy chargée, qui durcit et se solidifie.

5. Procédé selon la revendication 1, **caractérisé** en ce qu'on recouvre et on isole le circuit à l'aide d'une goutte de silicone, on le couvre d'un capôt constitué d'une feuille métallique (ZF, KF) et on le soude sous une faible pression au moyen d'un laser YAG au néodyme.

6. Procédé selon la revendication 1, **caractérisé** en ce que, dans le cas de circuits de micro-électronique qui supportent des températures de 400° C pendant une courte durée, on isole les points de soudure prévus à l'aide de diélectrique appliqué par impression, on les cuit, on applique après mise en place des éléments et des fils une brasure à base d'argent et de verre avec une teneur en argent d'environ 70% sur les points de soudure, on les chauffe à 300° C pendant environ 15 minutes puis on soude un capôt constitué d'une feuille métallique à 380° C pendant 30 minutes en présence d'une faible pression - par exemple dans un moule en carbone.

7. Procédé selon l'une ou plusieurs des revendications 1 à 6, **caractérisé** en ce qu'on réalise la soudure de la feuille métallique (ZF) à l'aide d'un laser YAG au néodyme de faible puissance et avec une faible focalisation.

8. Procédé selon l'une ou plusieurs des revendications 1 à 7, **caractérisé** en ce qu'on utilise comme procédé de soudage, le soudage par résistance connu en soi, de préférence par induction, ce dernier étant réalisé au moyen d'un poinçon chauffé de forme adaptée, de préférence de céramique cuivrée avec une feuille de Sn ou une feuille de Cu ou une feuille de Al avec des couches d'argent ou de palladium.

FIG. 1a

# FIG. 1

# FIG. 2a

1. FORMWERKZEUG

MATRIX

FOLIE

FORMBACKEN

STEMPEL

# FIG. 2b

2. FORMWERKZEUG
(BÖRDELUNG)

FOLIE

# FIG. 2c

HS

ZF

F   LB   B   D   S